(19) Europäisches Patentamt
European Patent Office
Office européen des brevets

(11) **EP 4 575 048 A1**

(12) **EUROPEAN PATENT APPLICATION**

(43) Date of publication:
**25.06.2025 Bulletin 2025/26**

(21) Application number: **23217980.4**

(22) Date of filing: **19.12.2023**

(51) International Patent Classification (IPC):
***C30B 23/06*** (2006.01)     ***C30B 29/36*** (2006.01)

(52) Cooperative Patent Classification (CPC):
**C30B 23/06; C30B 29/36**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **SiCrystal GmbH
90411 Nürnberg (DE)**

(72) Inventors:
• **Ecker, Bernhard
90411 Nürnberg (DE)**
• **Klietz, Wenzel
90411 Nürnberg (DE)**

• **Müller, Ralf
90411 Nürnberg (DE)**
• **Schuh, Philipp
90411 Nürnberg (DE)**
• **Stockmeier, Matthias
90411 Nürnberg (DE)**
• **Vogel, Michael
90411 Nürnberg (DE)**

(74) Representative: **Grünecker Patent- und
Rechtsanwälte
PartG mbB
Leopoldstraße 4
80802 München (DE)**

Remarks:
Amended claims in accordance with Rule 137(2)
EPC.

(54) **ARRANGEMENT FOR GROWING A SIC VOLUME MONOCRYSTAL AND GROWING METHOD**

(57)     The present invention relates to an arrangement for growing a SiC volume monocrystal in a cavity (110) by sublimation growth in a direction of growth (Y). The arrangement comprises a susceptor (100) for absorbing electromagnetic energy, the susceptor (100) for heating the cavity (110); and an insulator (200) surrounding the susceptor (100), the insulator (200) for thermally insulating the susceptor (100) from an exterior of the arrangement. The insulator (200) comprises a thermal insulation wall (202) surrounding the susceptor (100) in the direction of growth (Y) and a circumferential direction (c), the thermal insulation wall (202) for reducing heat transfer in a radial direction (r) from the susceptor (100) to the exterior outside the arrangement, the radial direction (r) being perpendicular to the direction of growth (Y); a thermally conductive layer (210) disposed between said susceptor (100) and said thermally insulating wall (202), said thermally conductive layer (210) having a higher thermal conductivity than said thermally insulating wall (202), for distributing heat on said thermally conductive layer (210); wherein the thermally conductive layer (210) is spaced from the susceptor (100) to reduce heat transfer from the susceptor (100) to the insulator (200) caused by thermal conduction, and the thermally conductive layer (210) is disposed on the thermal insulation wall (202), thereby reducing waviness of the insulator (200) to increase reflectivity of the insulator (200).

Fig. 3

**Description**

The present application relates to an arrangement for growing a SiC volume monocrystal and growing method.

Due to its excellent physical, chemical, electrical and optical properties, silicon carbide (SiC) is used as a semiconductor material for high-frequency components and for special light-emitting semiconductor components, including as a starting material for power semiconductor components. For these components, SiC substrates, such as those described in US Patent US 8,747,982 B2, with large substrate diameters (equal to or greater than 200 mm) and high quality are required.

Using suitable starting material, SiC mono crystals are grown, for example, by the physical vapor deposition (PVT) process as disclosed, for example, in US 8,865,324 B2. The crystals are then sliced into SiC substrates using wire saws or similar slicing techniques, and the surface is then refined using multi-stage polishing steps. In the subsequent epitaxy processes, thin monocrystalline layers (e.g. SiC, GaN) are first deposited on the SiC substrates. The properties of these layers and the resulting devices depend on the quality of the SiC substrate.

Growing SiC crystals is a very energy intensive and therefore expensive process. Every energy saving with the same or increased crystal leads to an increase in the economic efficiency of the resulting electrical components. It has been proposed to use insulators, as described for example in the German Patent DE 10 2009 004 751 B4. In this way, energy can be saved and quality can be ensured.

At the same time, the loss of quality in crystal growing leads to enormous costs. In order to achieve a high yield in crystal growing, it is necessary to be able to use starting materials and auxiliary materials of consistent quality, especially the insulator, which must meet high requirements such as cleanliness, temperature stability, and transparency to electromagnetic fields.

In view of the above, it is an object is to reduce costs and save energy. At the same time, it is an object that materials are selected that allow defined temperature profiles to be set (which are consistent from growth to growth) to ensure quality. For the growth of high quality SiC crystals, it is further an object that a defined temperature profile prevails in the growth setup. Another objective is to use materials that can be used at high temperatures. A further object is that the material can be used under vacuum conditions and meet the requirements of cleanliness.

At least one of these objects is solved by the subject matter of the independent claims. Advantageous embodiments are solved by the dependent claims.

According to a general aspect, it is proposed to optimize the surface of the insulator. More specifically, insulators that can be used for crystal growth applications usually have a wavy surface and a structure with varying density. This has a double negative effect on crystal growth.

More specifically, the usually fiber-based microstructure results in a surface with strong undulations and voids. This results in a non-optimal and inhomogeneous return of energy to the susceptor due to the non-optimal reflection of thermal radiation from the insulation to the surface. Instead, the insulation heats up due to unwanted absorption or because direct backscatter to the susceptor is not possible due to the unfavorable insulation surface. In areas of low fiber density (large voids), more of the radiant energy from the crucible is absorbed by the insulation, and in areas of high fiber density (small voids), less radiant energy is absorbed.

These localized hot spots in the isolation create unwanted temperature inhomogeneities that randomly and uncontrollably affect the temperature field during growth and can negatively affect the quality of the grown crystal. This issue is further exacerbated by the manner in which the isolation is produced. Production-related gradual inhomogeneities in the insulation due to fiber agglomeration or depletion in the insulation also lead to the described hot spots in the insulation, which are also difficult to control and influence.

In summary, modern insulation negatively affects crystal growth in two ways: Insufficient heat return to the susceptor by thermal radiation due to the surface structure and insufficient homogeneity of the temperature field due to fiber inhomogeneities and the formation of hot spots in the insulation.

By optimizing the insulator surface, the yield and quality of crystals is increased by leveling the hot spots in the isolation (increasing homogeneity, even from growth to growth) and by increasing the reflectivity of the isolation surface to the susceptor (energy efficiency).

The inventors have found that both disadvantages can be virtually eliminated by surface treatment of the insulator, in particular by coating, infiltrating and/or foiling the surface of the insulator. In more detail, coating, infiltration, and foiling increase the energy return to the susceptor, and the insulation effect can be significantly homogenized. Thermal radiation striking the optimized insulation surface from the susceptor can be directly and directionally reflected back to the susceptor along the entire length of the insulation. In addition, since the coating, infiltration, and foil each have a higher thermal conductivity than the original insulation, temperature inhomogeneities (hotspots) in the axial direction of the insulation can be compensated.

Although the increased thermal conductivity slightly increases the energy absorption, since the electromagnetic coupling is usually higher in such materials, this effect is more than offset by the increase in homogeneity and its effect on the crystals produced.

In more detail, a first aspect relates to an arrangement for growing, in a cavity, which is usually formed by a crucible, a SiC volume monocrystal by sublimation growth in a direction of growth. Silicon Carbide crystals are commonly grown using the Physical Vapor Transport (PVT) method, specifically sublimation. The growth starts at a seed crystal placed in the crucible and the seed crystal growth in the direction of growth in the crucible thereby forming a larger SiC crystal. The growth take place usually in the crucible surrounding the cavity.

In more detail, arrangements for growing a SiC volume monocrystal usually comprise the crucible, which is a container designed to withstand high temperatures and is used for holding materials at extreme temperatures, wherein the seed crystal and source material is placed in the cavity. Further, the arrangement comprises a susceptor, which is a material that absorbs electromagnetic energy, usually in the form of microwaves or radio frequency waves, and converts it into heat. In short, while the crucible serves as a high-temperature container for holding and processing materials, the susceptor enhances the efficiency of heating processes, particularly in applications where microwave or radio frequency energy is utilized.

In the following, with susceptor is in particular referred to the combination of the crucible and the susceptor. This has the advantage for applications where precision, speed, and energy efficiency are paramount. Alternatively, the growing arrangement can comprise in addition to the susceptor the crucible.

The container, i.e. the crucible or the susceptor being an integral part of the crucible, provides in its interior the cavity in which the SiC volume mono crystal grows. An inner surface of the container faces the cavity. An outer surface of the container faces an insulator.

Advantageously, the container has a prism shape. A prism is a polyhedron comprising an n-sided polygonal base, a second base which is a translated copy (rigidly moved without rotation) of the first, and n other faces forming a side wall, joining corresponding sides of the two bases. Thus, a closed cavity is realized. This prism shape enables that the SiC volume mono crystal can be easily removed from the cavity, namely parallel to the faces forming the side wall. Frequently, the container has a cylindrical shape, i.e. the bases have a circular cross section.

Notably, geometries that can be used several times are advantageous because the cost of the containers are high. Thus, especially the geometry of the prism, in particular the geometry of a cylinder, is advantageous because the SiC volume mono crystal can be extracted along the direction of growth and dead spaces in the cavity can be reduced.

According to the first aspect, the insulator surrounds the susceptor. Thus, the insulator thermally insulates the susceptor from an exterior of the arrangement. A thermal insulator is a material specifically designed to reduce or prevent the transfer of heat between objects with different temperatures, i.e. between the susceptor being heated during the growing and the exterior being at ambient temperature. Its primary function is to impede the flow of heat energy through conduction, convection, and radiation.

As used herein, the insulator surrounds the surface of a susceptor, which means that the insulator encloses or encompasses the outer part of the susceptor, covering at least a part of its entire exterior. In particular, the insulator is in close proximity to the susceptor.

Further, according to the first aspect, the insulator comprises a thermal insulation wall surrounding the susceptor in the direction of growth and a circumferential direction. Thus, the insulator extends in two dimensions, namely the direction of growth, i.e. a longitudinal direction, and a circumferential direction of the susceptor. As used herein, this means that the insulator has dimensions or components that stretch both along its length (longitudinal) and around its circumference (circumferential).

The longitudinal direction refers to the lengthwise dimension of an object, often considered along its primary axis, i.e. the direction of growth of the SiC crystal. For example in case of a tube or cylinder, the longitudinal direction is the direction from one end to the other.

The circumferential direction refers to the direction around the outer boundary or surface of the susceptor. In the case of a container having a shape of a cylinder, the circumferential direction would be the circular path around the outside.

So, the thermal insulation wall extending in both longitudinal and circumferential directions has features or dimensions that span both its length and the perimeter around the outer surface of the susceptor. For example, in the case of cylindrical or tubular objects, where there is a dimension along the length and a dimension around the circumference, the insulator forms a hollow cylinder.

Notably, the insulator can comprises for thermal insulation further segments to entirely encompass the susceptor. E.g. if the susceptor has a cylinder shape, the insulator can comprise insulating bases, i.e. segments that extend in the radial dimension and the circumferential dimension.

In view of the above, the thermal insulation wall according the first aspect, reduces a heat transfer in a radial direction from the susceptor to the exterior outside the arrangement, the radial direction being perpendicular to the direction of growth.

Especially in the context of growth arrangements, an insulator extending in the longitudinal and circumferential directions is advantageous because the surface area defined by these two dimensions is usually the largest surface area of the container. In addition, the temperature in the growth direction must be controlled particularly precisely. Furthermore, in the case of induction heating, the susceptor is usually heated in the circumferential direction, and thus, a thermal insulation wall surrounding the susceptor in the circumferential direction is particularly advantageous.

Further, according to the first aspect, a thermally conductive layer is disposed between said susceptor and said thermally insulating wall, said thermally conductive layer having a higher thermal conductivity than said thermally insulating wall, for distributing heat on said thermally conductive layer.

As user herein, thermally conductive layer is a material or coating designed to efficiently transfer heat. Its primary purpose is to enhance the thermal conductivity in the layer, facilitating the rapid and effective movement of heat from one point at the layer to another.

Further, according to the first aspect, the insulator comprises the thermally conductive layer, which is spaced from the susceptor to reduce heat transfer from the susceptor to the insulator caused by thermal conduction.

Heat transfer can occur through various mechanisms, two of which are thermal conduction and thermal radiation. Thermal conduction is a mode of heat transfer that occurs through direct microscopic interaction of particles within a material or between different materials in direct contact. In this process, heat energy is transferred from higher-temperature regions to lower-temperature regions within a substance without any overall movement of the substance itself. Thermal radiation involves the transfer of heat through electromagnetic waves, such as infrared radiation. Unlike conduction, it doesn't require a material medium; heat is transferred through a vacuum or transparent medium.

Thus, by spacing the susceptor to from the insulator apart, the usually more effective thermal conduction is reduced and the heat transfer can be described with thermal radiation, in particular because the arrangement is used under vacuum conditions. Thus, by spacing the thermal conductive layer apart from the susceptor the thermally conductive layer can contribute to the thermal insulation. A larger space, however, increases the whole arrangement. As the arrangement is usually operated under vacuum conditions, the space should be saved.

For example, the susceptor and the thermally conductive layer are spaced apart, i.e. separated, by a distance in the radial direction equal to or greater than 0.1 mm, preferably equal to or greater than 0.5 mm, even more preferably equal to or greater than 1 mm. Additionally or alternatively, the susceptor and the thermally conductive layer are spaced apart by a distance in the radial direction equal to or less than 5 cm, preferably 1 cm, even more preferably 5 mm.

Further, according to the first aspect, the thermally conductive layer is disposed on the thermal insulation wall, thereby reducing the waviness of the insulator to increase the reflectivity of the insulator.

The term waviness in the context of reflectivity refers to variations or irregularities in the reflective surface of a material or object. Waviness can affect how light or electromagnetic waves interact with a surface and the resulting reflection characteristics. In particular, waviness often manifests itself as surface roughness on a reflective material. Microscopic irregularities or undulations on the surface can cause scattering and diffusion of reflected light. The degree of waviness or roughness can affect the specular reflection (mirror-like reflection) and diffuse reflection (scattered reflection) properties of the surface. In general, a higher value of waviness results in a lower reflection.

Thus, by reducing the waviness of the insulator, the reflectivity of the surface is increased and the loss by thermal radiation is reduced because the amount of thermal radiation that is reflected or scattered back to the susceptor (and absorbed by the susceptor) is increased.

In other words, the thermally conductive layer increases the energy return to the susceptor and the insulation effect can be significantly homogenized. Thermal radiation that hits the optimized insulation surface from the susceptor can be reflected directly and directionally back towards the susceptor over the entire length of the insulation. Further, the higher thermal conductivity of the thermally conductive layer balances temperature inhomogeneities (hotspots) in the axial direction of the insulation. Although the increased thermal conductivity slightly increases the energy absorption, as the electromagnetic coupling is usually higher in such materials, the effect is more than compensated for by the increase in homogeneity and its effects on the crystals produced.

Advantageously, the susceptor has a higher absorption than the thermally conductive layer. For example, based on the different kind of materials used for susceptors and insulation the absorption is different.

According to a second aspect, a thermal conductivity ratio of the thermal conductivity of the thermally conductive layer to the thermal conductivity of the thermal insulation wall is greater than or equal to 10. Advantageously, the ratio is greater than or equal to 14. Even more advantageously, the ratio is greater than or equal to 18.

The thermal conductivity ratio refers to the ratio of the thermal conductivity of one material, i.e. the thermal conductivity of the thermally conductive layer, to another, i.e. the thermal conductivity of thermal insulation wall.

Note that thermal conductivity can vary with temperature, so it's here considered the temperature relevant to the specific application when comparing materials. Here, the reference temperature is considered to be the temperature at which the SiC volume monocrystal is grown, which is in the range of 2000 to 2400 °C. Notably, the exact temperature can vary depending on the specific SiC polytype desired (e.g., 4H-SiC, 6H-SiC), the growth parameters, and the equipment used in the PVT process. In particular, a medium temperature at 2200 °C is considered to be relevant for the thermal conductivity.

In addition, different materials may have anisotropic thermal conductivity, i.e. meaning that the conductivity may vary with direction, i.e. the circumferential direction and the direction of growth. In such cases, a medium anisotropic thermal conductivity is considered to be relevant.

The higher the thermal conductivity, the better the heat can be distributed. This is important, for example, in cases where local hot spots in the insulation lead to unwanted temperature inhomogeneities, which have an uncontrollable influence on the temperature field during growth on a random basis and can have a negative effect on the quality of the grown crystal. This aspect is further exacerbated by the manner in which the insulation is produced. Production-related gradual inhomogeneities in the insulation due to fiber agglomerates or depletions in the insulation also lead to the described hot spots in the insulation, which are also difficult to control and influence, and thus, the thermal conductivity of the thermally conductive layer is of great importance.

According to a third aspect, in addition to any of the preceding aspects, the thermally conductive layer is arranged, i.e. disposed, on the thermal insulation wall by at least one of coating, infiltrating, and foiling the thermal insulation wall. Thus, the thermally conductive layer and the thermal insulation wall can be brought particularly close to each other so that the heat transfer by conduction between the thermal insulation wall and the thermally conductive layer is increased. Thus, heat generated in hot spots of the thermal insulation wall can be efficiently distributed on the thermally conductive layer, thereby mitigating the effect of thermal hot spots.

To optimize thermal conductivity, these layers are usually applied in thin and uniform layers. This ensures a close interface between the layers and minimizes thermal resistance.

In particular, surface coatings and infiltrations can be applied to mitigate waviness and enhance reflection properties. Reflective coatings, for example, are designed to maximize reflections by reducing surface irregularities. These coatings are crucial in applications where precise control over reflected light is essential. Infiltration of a surface relate to the process of substances penetrating or permeating the surface of a material.

According to a fourth aspect, in addition to the third aspect, the thermally conductive layer is arranged on the thermal insulation wall by coating and/or infiltrating a metal carbide. Metal carbide coatings have excellent hardness, wear resistance, and high-temperature stability. Preferably, the metal comprises a refractory metal carbide. These refractory metal carbides are chosen based on the specific requirements of the application, considering factors such as temperature resistance, wear resistance, and chemical compatibility. The coating and infiltration methods may include thermal spraying, physical vapor deposition, or chemical vapor deposition, depending on the material and desired properties. In particular, these can be deposited on the insulation material both from the gas phase and from solution and then produce a homogeneous, smoothed surface.

It has been found out that in particular, Tantalum carbide (TaC), Tungsten Carbide (WC), and Hafnium Carbide (HfC) are advantageous in view of having high melting points, being wear-resistant, and having a high hardness.

According to a fifth aspect, in addition to the third and fourth aspect, the thermally conductive layer is arranged on the thermal insulation wall by applying a foil to the thermal insulation wall. A foil enables similar technical effect as a coated or infiltrated surface. In particular, the foil can comprise or be made of a graphite. Graphite foil is a thin, flexible material made of layers of graphene sheets. It possesses unique properties due to the structure of graphite, which is composed of carbon atoms arranged in hexagonal patterns. In particular, a graphite foil is an excellent conductor of heat. Further, graphite is chemically inert, meaning it is resistant to many corrosive substances. This property makes graphite foil suitable for use in harsh environments where exposure to extreme temperatures, as in the growing arrangement, is a concern.

Preferably, the foil comprises exfoliated graphite. Exfoliated graphite refers to a form of graphite that has undergone a process called exfoliation, resulting in the expansion and separation of individual graphene layers. Exfoliated graphite exhibits anisotropy in thermal conduction due to its layered structure. The thermal conductivity of exfoliated graphite is highly dependent on the direction in which heat is transferred relative to the planes of the graphene layers. The anisotropic thermal properties are a consequence of the differences in thermal conduction within the planes (in-plane) and perpendicular to the planes (out-of-plane).

Thus, the anisotropic thermal conduction can be used so that a higher thermal conductivity parallel to the symmetry axis of the growing arrangement, i.e. in the direction of growth, and therefore ideal for equalizing temperature inhomogeneities along the insulation and a providing a smooth surface for high reflection. In particular, the in-plane direction shows higher thermal conductivity as explained above, i.e. hexagonal pattern. Thus, this is advantageously to even out inhomogeneities and hot spots in the insulation material.

According to a sixth aspect, in addition to any of the preceding aspects, the thermal insulation wall comprises or consists of a felt. Felts are versatile materials that can be used for thermal insulation due to its fibrous structure, which creates a network of air pockets that resist the flow of heat.

Advantageously, the felt can comprises at least one of a soft felt, a hard felt, and a combination of soft felt and hart felt.

The felt, which is advantageous for the arrangement, has a fiber-based microstructure that results in a surface with strong undulations and cavities. This results in a non-optimal and nonhomogeneous return of energy towards the susceptor due to non-optimal reflection of heat radiation from the thermal insulation wall. Instead, the thermal insulation wall heats up due to undesired absorption or because direct backscattering towards the susceptor is not possible due to the disadvantageous thermal insulation wall surface. In areas with low fiber density (large cavities) more of the radiant energy coming from the crucible is absorbed in the thermal insulation wall and in areas with high fiber density (small cavities) less radiant energy is absorbed. The negative effects are compensated by the thermally conductive layer discussed above.

The thermal insulation wall material can comprise or consist of short carbon fibers that are held together by a binder matrix (hard felt) and/or long carbon fibers that are consolidated by needling (soft felt).

Hard felt can be formed into the desired form, e.g. hollow cylinders, during the manufacturing process, which then take on a rigid shape. Soft felt is usually produced as a sheet-like mat with a thickness of approx. 5 mm to 25 mm. This mat can then be cut as required, wound up and processed into the desired form, e.g. a hollow cylinder, by sewing, for example. Hybrid solutions are also conceivable in which, for example, a soft felt mat is wound onto a hard felt cylinder and fixed to it or a soft felt mat is rolled and enclosed by a hard felt cylinder.

According to a seventh aspect, in addition to the sixth aspect, the thermal insulation wall comprises or consists of a graphite insulation material having short carbon fibers with a fiber length in a range of between 1 mm and 10 mm and a fiber diameter in a range of between 0.1 mm and 1 mm, wherein the short carbon fibers are bonded by a resin thereby forming a hard felt. Alternatively or additionally, the thermal insulation wall comprises by graphite insulation material having long carbon fibers with a fiber length or greater than 10, wherein the long carbon fibers are bonded by needling to form a soft felt.

According to an eight aspect, in addition to any of the preceding aspects, the thermal insulation wall is formed by a hollow cylinder extending in the direction of growth and surrounding in the circumferential direction the susceptor. With respect to the geometry of a hollow cylinder is referred to the above description. Advantageously, a plurality of coaxial hollow cylinder layers are nested one inside the other, each cylinder layer having a different radius and the cylinder having the smallest radius comprises has the thermally conductive layer on an inner surface facing the susceptor. Thus, different materials for different applications can be realized.

According to an ninth aspect, in addition to any of the preceding aspects, a ratio of a reflectivity ratio of the thermally conductive layer to a reflectivity ratio of the thermal insulation wall is greater than or equal to 1.3. The reflectivity ratio, also known as the reflectance ratio, is a measure of how much light or other electromagnetic radiation is reflected by a surface compared to how much is incident upon it. Thus, with the higher reflectivity ratio of the thermally conductive layer, the insulating properties of the insulator can be increased compared to an arrangement without thermally conductive layer. Advantageously, the ratio is greater than or equal to 1.4. Even more preferably, the ratio is greater than or equal to 1.5.

According to a tenth aspect, in addition to any of the preceding aspects, a waviness height of the thermally conductive layer is less than or equal to 2 mm. Preferably, waviness height of the thermally conductive layer is less than or equal to 1 mm. Even more preferably, the waviness height of the thermally conductive layer is less than or equal to 0.5 mm.

Waviness height refers to the vertical distance between the highest peak and the lowest valley of a surface profile within a specified sampling length. It is a measure of the amplitude of the irregularities or undulations present on a surface. Waviness is distinct from roughness, with the former typically representing longer wavelength variations in a surface profile. Waviness height is defined by the irregularities that have frequencies lower than those associated with roughness. These irregularities often occur over longer distances on a surface. Thus, waviness height is more appropriate for defining surface properties in view of longer wavelength, i.e. the radiation at a temperature of the 2000 °C resulting in a wavelength in the micrometer range, than surface roughness, which is more important for shorter wavelength, i.e. wavelength in a nanometer range. Waviness height can be measured using techniques such as profilometry or interferometry. As a general rule, the smaller the waviness height, the higher the reflectivity.

According to an eleventh aspect, in addition to any of the preceding aspects, a thickness ratio of a thickness in the radial direction of the thermally conductive layer to a thickness in the radial direction of the thermal insulation wall is less than or equal to 1/10, preferably, is less than or equal to 1/15, even more preferably is less than or equal to 1/20.

A thin thermally conductive layer reduces the influence to the insulation property of the thermal insulation wall. If the coating/infiltration/foil is thicker, too much of the electromagnetic radiation already couples into the coating and heats up the insulation so much that it degrades considerably and at the same time too little of the energy couples into the susceptor, meaning that is more difficult to bring the arrangement to the desired temperature.

Further, apart from the pure insulation effect, in case of an induction heating described below, the electromagnetic field of the coil shall not couple into the insulation material and heat up the insulation itself. The insulation must be permeable to the electromagnetic field and ensure the lowest possible losses so that the energy couples directly into the growing susceptor (which can be part of the crucible) and heats the source material inside. Thus, a thin thermally conductive layer is in particular advantageous for an inductive heating.

A typical thickness of the thermal insulation wall is in greater than or equal to 5 mm, even more preferably 1 cm. Further, the thickness of the thermal insulation wall is less than or equal to 15 cm, preferably less than 10 cm, even more preferably less than 5cm.

According to a twelfth aspect, in addition to any of the preceding aspects, the insulator further comprises at least one heat insulating cover for covering the susceptor.

There are two different positions for the use of insulation material in the SiC growth setup. On the one hand, insulation material is arranged below and above the growth susceptor and, on the other hand, hollow single-part or multi-

EP 4 575 048 A1

part insulation cylinders are placed over the susceptor, which surround the susceptor in the circumferential and longitudinal direction extending in the radial direction.

A thirteenth aspect relates to a system comprising the arrangement according to any of the preceding aspects, wherein the system further comprises at least one of an induction heater, wherein the induction heater surrounds the insulator; a resistance heater, where the resistance heater is surrounded by the insulator; a reactor for housing the arrangement; and a vacuum pump for evacuating the system, in particular the reactor.

Thus, heating is provided by at least one of induction coils, which are installed outside a reactor, or by resistance heaters, which are installed inside a reactor. Additionally, the arrangement can be placed in the reactor, wherein in the reactor the actual crystal growth takes place. The arrangement for growing comprises different graphite and insulation materials, the seed and the source material, which are placed inside the cavity formed in the reactor, namely in the crucible. In general, the arrangement comprises carbon-based materials, as these can withstand the high temperatures and at the same time are not a source of impurities for the SiC crystal.

The insulator is intended to ensure that as little of the energy introduced into the susceptor as possible is released to the outside, but is available to heat the susceptor as much as possible. The arrangement, comprising of the susceptor and the insulator, is housed in the reactor, preferably in an intergas atmosphere of less than 50 mbar. In accordance with the law of radiation, the susceptor emits some of the induced energy outwards towards the insulator. As discussed above, the insulator is usually located away from the susceptor, so the heat transfer from the susceptor to the insulator is mainly through thermal radiation.

Additionally, the arrangement can comprise devices for measuring the temperature, pyrometers, thermocouples, or the like. The vacuum-sealed reactor can be evacuated by one or more vacuum pumps. Furthermore, the system can be supplied with inert and/or doping gases (e.g. nitrogen) via one or more gas supply lines and the pressure in the system can be measured and controlled. All process parameters (pressure, temperature, gas flows ...) can be set, monitored and archived by a computer-controlled system controller. The system control communicates with all components involved (e.g. inverter, pyrometer, vacuum control valve, MFC, pressure gauges).

A fourteenth aspect relates to a method for growing a SiC volume mono crystal by sublimation growth in a direction of growth in a cavity, the method comprising the steps of:
Providing a SiC seed crystal and SiC source material in the cavity:

Heating a susceptor to grow the SiC volume mono crystal in the cavity;

Isolating the susceptor with an insulator, wherein the insulator comprises:

a thermal insulation wall surrounding the susceptor in the direction of growth (Y) and a circumferential direction, the thermal insulation wall for reducing heat transfer in a radial direction (r) from the susceptor to the exterior outside the arrangement, the radial direction (r) being perpendicular to the direction of growth (Y);

a thermally conductive layer disposed between said susceptor and said thermally insulating wall, said thermally conductive layer having a higher thermal conductivity than said thermally insulating wall, for distributing heat on said thermally conductive layer;

wherein the thermally conductive layer is spaced from the susceptor to reduce heat transfer from the susceptor to the insulator caused by thermal conduction, and the thermally conductive layer is disposed on the thermal insulation wall, thereby reducing waviness of the insulator to increase reflectivity of the insulator.

With regards description of the method is referred to the description of above aspects 1 to 13. In particular, the same terminology has been used, e.g. cavity, susceptor, insulator, thermal insulation wall, and thermally conductive layer, and thus, a description of the terms used in the method is omitted. In particular, the method can be executed by using an arrangement of any of the above aspects 1 to 13.

Advantageously, according to a fifteenth aspect, in the method according to the fourteenth aspect the thermally conductive layer increases the reflectivity so that thermal energy supplied during heating to the susceptor is reduced by more than or equal to 5%, preferably wherein the thermal energy supplied to the cavity is reduced by more than or equal to 10%. For example, the energy supplied is reduced by the measures described with reference to any of the aspects two to twelve.

The invention will now be described in greater detail and in an exemplary manner using advantageous aspects and with reference to the drawings. The described aspects are only possible configurations in which, however, the individual features as described above can be provided independently of one another or can be omitted.

The accompanying drawings are incorporated into the specification and form a part of the specification to illustrate several embodiments of the present invention. These drawings, together with the description, serve to explain the principles of the invention. The drawings are for the sole purpose of illustrating the preferred and alternative examples of how the invention can be made and used, and are not to be construed as limiting the invention to the illustrated and described embodiments only. Furthermore, several aspects of the embodiments, individually or in different combinations, may form solutions according to the present invention. Thus, the embodiments described below may be considered either alone or in an arbitrary combination thereof.

The described embodiments are merely possible configurations and it must be borne in mind that the individual features as described above can be provided independently of one another or can be omitted altogether while implementing this invention. Further features and advantages will become apparent from the following more detailed description of the various embodiments of the invention, as illustrated in the accompanying drawings, in which like references refer to like elements, and wherein:

In the figures, are:

**FIG. 1** a system with an arrangement according to an example;
**FIG. 2** a thermal insulation wall interacting with a susceptor;
**FIG. 3** the arrangement of Fig. 2 with an additional thermally conductive layer; and
**FIG. 4** a flow diagram for growing a SiC volume mono crystal.

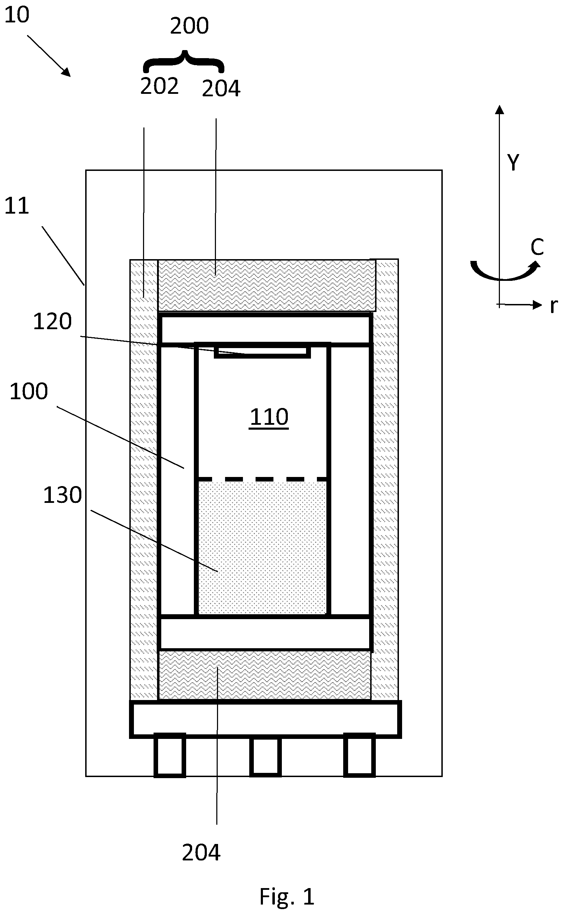

The invention is now described with reference to the Figures and first with reference to Fig. 1, which describes a system 10 for growing, in a cavity 110, a SiC volume monocrystal. In more detail, Fig. 1 shows a system 10 that comprises a susceptor 100 and a reactor 11 forms a chamber, wherein the susceptor 100 is arranged in the chamber. Further, an insulator 200 surrounds the susceptor 100. As discussed above, the susceptor 100 forms a crucible with a cavity for growing the SiC volume monocrystal. Alternatively, according to a not shown example, the susceptor 100 can be provided separate from the crucible.

In the susceptor 100 is provided at a first end a SiC seed crystal 120 and SiC source material 130.

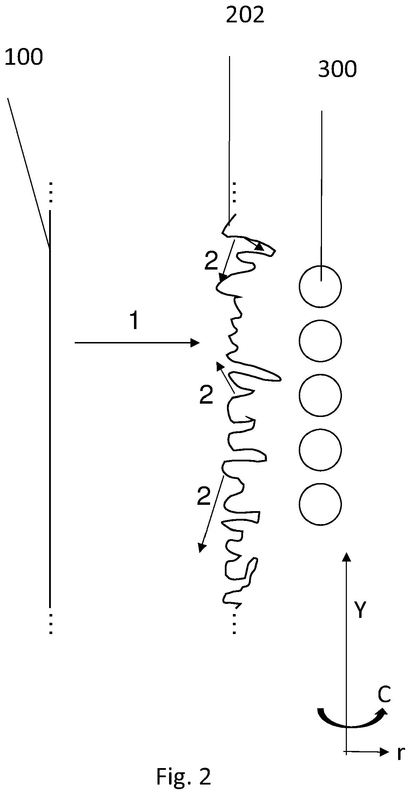

The insulator 200 comprises a thermal insulation wall 202 surrounding the susceptor 100 in the direction of growth Y and a circumferential direction C. In particular, as shown in the example of Fig. 2, the thermal insulation wall 202 forms a hollow cylinder extending in the direction of growth Y and in the circumferential direction C. The thermal insulation wall 202 reduces heat transfer in a radial direction r from the susceptor 110 to the exterior outside the arrangement. In particular, the radial direction r is perpendicular to the direction of growth Y

Further, the insulator 200 comprises two heat insulating covers 204 for covering the susceptor. The heat insulating cover 204 can be made of the same material as the insulation wall 202.

According to one example, the thermal insulation wall 202 comprises a felt, for example a soft felt, a hard felt, or a combination thereof. A hard felt comprises short carbon fibers with a fiber length in a range of between 1 mm and 10 mm and a fiber diameter in a range of between 0.1 mm and 1 mm, wherein the short carbon fibers are bonded by a resin thereby forming a hard felt. A soft felt comprises long carbon fibers with a fiber length or greater than 10, wherein the long carbon fibers are bonded by needling to form a soft felt.

As shown in Fig. 1, the reactor 11 houses the arrangement, which comprises the susceptor 100 and the insulator 200. Not shown is a vacuum pump for evacuating the reactor 11.

The system 10 can further comprise a not shown heater, which is arranged in the reactor 11. For example, the system can comprise an induction heater, wherein the induction heater can surround the insulator 200. Additionally or alternatively, also not shown, the system 10 can comprise a resistance heater, where the resistance heater is surrounded by the insulator 200.

The thermal insulation wall 202 of Fig. 1 is schematically shown in Fig. 2. In particular, in the example shown in Fig. 2, an induction heating 300 heats the susceptor 100. Alternatively, a not shown resistance heating can be provided. In other words, the susceptor 100 absorbs electromagnetic energy from the heater, is thereby heated, and thus, the cavity surrounded by the susceptor 100 is heated.

As shown in Fig. 2, the thermal insulation wall 202 is spaced from the susceptor 100 to reduce heat transfer from the susceptor 100 to the insulator caused by thermal conduction. In other words, the heat transfer from the susceptor 100 to the thermal insulation wall 202 is caused by radiation, which is described by Stefan-Boltzmann's law (1):

$$Q = \varepsilon * \sigma * A * T^4 \qquad\qquad (1)$$

In expression (1) a radiating body is described. Q is the radiant power, $\varepsilon$ the (material-dependent) emissivity, $\sigma$ the Stefan-Boltzmann constant, A the radiating area and T the absolute temperature of the radiator.

As indicated in Fig. 2, radiation 1 from the susceptor 100 is radiated to the thermal insulation wall 202. In view of the waviness of the thermal insulation wall 202, the reflected radiation 2 is not directed to the wall of the susceptor 1100. Rather, the probability is high that the reflected radiation 2 interacts again with the thermal insulation wall 202, and thus, the probability that reflected radiation 2 is absorbed by the thermal insulation wall 202 is increased.

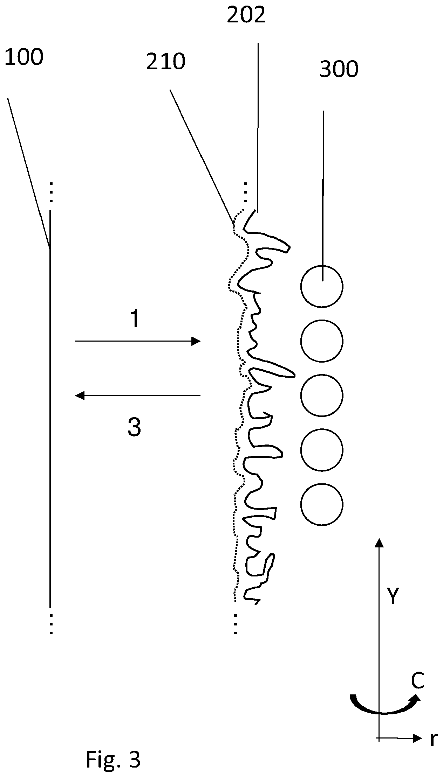

Alternatively, as shown in Fig. 3, a thermally conductive layer 210 is disposed between said susceptor 100 and said thermal insulating wall 202. For example, the thermally conductive layer 210 is arranged on the thermal insulation wall 202 by at least one of coating, infiltrating, and foiling the thermal insulation wall 202.

As shown in Fig. 3, the thermally conductive layer 210 reduces the waviness of the insulator and increases the reflectivity of the insulator. In particular, after interaction with the surface of the thermally conductive layer 210, the radiation 1 is a redirected radiation 3 directed to the susceptor 100. Thus, the probability that radiation is redirected to the susceptor 100 is increased. Thus, the thermally conductive layer 210 reduces the amount of radiant power Q that is transferred from the susceptor 100 to the insulator 200. Notably, redirection may comprise processes such as refection and scattering.

Further, the thermally conductive layer 210 has a higher thermal conductivity than the thermally insulating wall 202. Thus, the remaining part of heat that is absorbed by the thermally conductive layer 210 is distributed in the thermally conductive layer 210 rather than bound by thermal insulating wall 202, as can be derived from Fourier's law (2):

$$Q = \lambda * A * (dT / dx) \qquad\qquad (2)$$

Here, Q is the transferred heat output, $\lambda$ is the thermal conductivity of the material, A is the cross-sectional area through which heat is transferred, and dT/dx is the temperature gradient along the direction of heat transfer.

Fourier's law describes the mechanism of heat conduction, which is relevant here for the homogenization of temperature inhomogeneities in the thermally conductive layer 210 of the insulator 200, and Stefan-Boltzmann's law describes heat transport by radiation, which describes the return of energy from the thermally conductive layer 210 of the insulator 200 to the susceptor 100.

Thus, the choose of the thermal conductivity counteracts the development of hot spots in the thermal insulating wall 202 and providing the surface with the thermally conductive layer 210 reduces the waviness, which in turn increases the return of energy from the insulator 200 to the susceptor 100.

As further shown in the schematic Fig. 3, the thermal insulation wall 202 is thicker than the thermally conductive layer 210. In particular a thickness ratio of a thickness in the radial direction r of the thermally conductive layer 210 to a thickness in the radial direction r of the thermal insulation wall 202 is less than or equal to 1/10, preferably, is less than or equal to 1/15, even more preferably is less than or equal to 1/20. The thinner the thickness, the less the probability of absorption of electromagnetic radiation, i.e. the field emitted by the induction heater 300 and the thermal radiation emitted by the susceptor 100.

According to an example, the thermal conductivity ratio of the thermal conductivity of the thermally conductive layer 210 to the thermal conductivity of the thermal insulation wall is greater than or equal to 10, preferably, is greater than or equal to 14, even more preferably is greater than or equal to 18. The higher the thermal conductivity ratio, the more efficient heat is distributed by the thermally conductive layer 210.

According to one example, the thermally conductive layer 210 is arranged on the thermal insulation wall 202 by coating and/or infiltrating a metal carbide. As shown in Fig. 3, groves in the surface of the thermal insulation wall 202 can be filled with coating and/or infiltration material. In particular, the metal can comprise or consist of a refractory metal, for example at least one of TaC, WC, and HfC. Thus, the waviness is reduced and the reflectivity of the insulator is increased.

According to another example, the thermally conductive layer 210 is arranged on the thermal insulation wall 202 by applying a foil to the thermal insulation wall 202. In particular, the foil comprises graphite, for example exfoliated graphite. Thus, the waviness is reduced and the reflectivity of the insulator is increased.

In particular, a waviness height of the thermally conductive layer 210 is less than or equal to 2 mm, preferably less than or equal 1 mm, even more preferably less than or equal to 0.5 mm. To measure the waviness height, the vertical distance, i.e. in the radial direction r, between the highest peak and the lowest valley of a surface profile, is determined within a specified sampling length, here in particular in the axial direction Y and/or the circumferential direction C.

According to another examples, the reflectivity of a reflectivity ratio of the thermally conductive layer to a reflectivity ratio of the thermal insulation wall is greater than or equal to 1.3, preferably, is greater than or equal to 1.4, even more preferably is greater than or equal to 1.5.

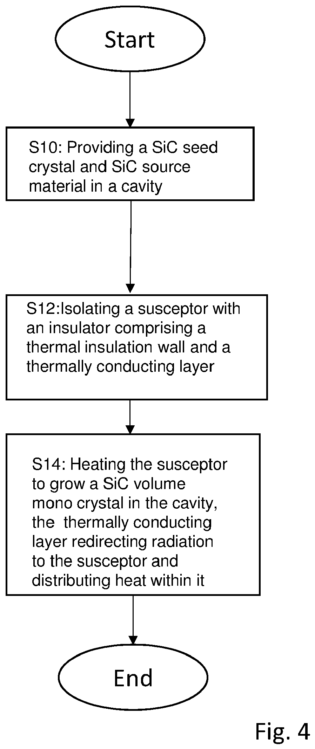

The method for growing such a SiC volume mono crystal by sublimation growth in a direction of growth Y is described in Fig. 4. According to the method, in a first step S10 a SiC seed crystal can be provided in the cavity of a reactor as shown for example in Fig. 1. The SiC seed crystal can be arranged at an end wall provided with a seed holder for holding the SiC seed crystal. The end wall extends perpendicular to the direction of growth. Additionally, SiC material can be provided in a storage region formed in the cavity.

The method further comprises the step S12 of isolating the susceptor with an insulator comprising a thermal insulation wall and a thermal conducting layer as for example described above in Fig. 3.

In more detail, a thermal insulation wall is arranged to surround the susceptor in a circumferential direction c and a direction of growth Y, the thermal insulation wall for reducing heat transfer in a radial direction r from the susceptor to the exterior outside the arrangement, the radial direction r being perpendicular to the direction of growth Y Further, the insulator is provided with a thermally conductive layer disposed between said susceptor and said thermally insulating wall, said thermally conductive layer having a higher thermal conductivity than said insulating wall, for distributing heat on said thermally conductive layer. In addition, the thermally conductive layer is arranged to be spaced from the susceptor to reduce heat transfer from the susceptor to the insulator caused by thermal conduction.

Further, the process comprises heating (step S14) a susceptor to grow the SiC volume mono crystal in the cavity. In particular, the thermally conductive layer is disposed on the thermal insulation wall, thereby reducing waviness of the insulator and thus, the reflectivity of the insulator is increased. During the heating, the thermally conducting layer redirects radiation emitted from the susceptor back to the susceptor.

In particular, the thermally conductive layer increases the reflectivity so that thermal energy supplied during heating in S14 to the susceptor is reduced by more than or equal to 5%, preferably wherein the thermal energy supplied to the cavity is reduced by more than or equal to 10%.

Notably, according to the examples discussed with the Figures, the susceptor 100 forms a crucible. According to not shown examples, a susceptor can be provided separate from the crucible.

Notably, according to a not shown example, a plurality of coaxial hollow cylinder layers are nested one inside the other, each cylinder layer having a different radius and the cylinder having the smallest radius comprises has the thermally conductive layer on an inner surface facing the susceptor.

**Claims**

1. Arrangement for growing a SiC volume monocrystal in a cavity (110) by sublimation growth in a direction of growth (Y), the arrangement comprising

    a susceptor (100) for absorbing electromagnetic energy, the susceptor (100) for heating the cavity (110); and
    an insulator (200) surrounding the susceptor (100), the insulator (200) for thermally insulating the susceptor (100) from an exterior of the arrangement, the insulator (200) comprising:

       a thermal insulation wall (202) surrounding the susceptor (100) in the direction of growth (Y) and a circumferential direction (c), the thermal insulation wall (202) for reducing heat transfer in a radial direction (r) from the susceptor (100) to the exterior outside the arrangement, the radial direction (r) being perpendicular to the direction of growth (Y);
       a thermally conductive layer (210) disposed between said susceptor (100) and said thermally insulating wall (202), said thermally conductive layer (210) having a higher thermal conductivity than said thermally insulating wall (202), for distributing heat on said thermally conductive layer (210);
       wherein the thermally conductive layer (210) is spaced from the susceptor (100) to reduce heat transfer from the susceptor (100) to the insulator (200) caused by thermal conduction, and the thermally conductive layer (210) is disposed on the thermal insulation wall (202), thereby reducing waviness of the insulator (200) to increase reflectivity of the insulator (200).

2. Arrangement according to claim 1, wherein a thermal conductivity ratio of the thermal conductivity of the thermally conductive layer (210) to the thermal conductivity of the thermal insulation wall (202) is greater than or equal to 10, preferably, is greater than or equal to 14, even more preferably is greater than or equal to 18.

3. Arrangement according to any of the preceding claims, wherein the thermally conductive layer (210) is arranged on the thermal insulation wall (202) by at least one of coating, infiltrating, and foiling the thermal insulation wall (202).

4. Arrangement according to claim 3, wherein the thermally conductive layer (210) is arranged on the thermal insulation wall (202) by coating and/or infiltrating a metal carbide, preferably wherein the metal carbide comprises a refractory metal carbide, optionally wherein the refractory metal carbide comprises at least one of TaC, WC, and HfC.

5. Arrangement according to claim 3 or 4, wherein the thermally conductive layer (210) is arranged on the thermal insulation wall (202) by applying a foil to the thermal insulation wall (202), preferably wherein the foil comprises graphite, optionally wherein the foil comprises exfoliated graphite.

6. Arrangement according to any of the preceding claims, wherein the thermal insulation wall (202) comprises a felt, preferably the thermal insulation wall (202) comprises at least one of a soft felt and a hard felt.

7. Arrangement according to claim 6, wherein the thermal insulation wall (202) comprises graphite insulation material comprising at least one of

short carbon fibers with a fiber length in a range of between 1 mm and 10 mm and a fiber diameter in a range of between 0.1 mm and 1 mm, wherein the short carbon fibers are bonded by a resin thereby forming a hard felt; and long carbon fibers with a fiber length or greater than 10, wherein the long carbon fibers are bonded by needling to form a soft felt.

8. Arrangement according to any of the preceding claims, wherein the thermal insulation wall (202) is formed by a hollow cylinder extending in the direction of growth (Y) and surrounding in the circumferential direction (c) the susceptor (100), preferably wherein a plurality of coaxial hollow cylinder layers are nested one inside the other, each cylinder layer having a different radius and the cylinder having the smallest radius comprises has the thermally conductive layer (210) on an inner surface facing the susceptor (100).

9. Arrangement according to any of the preceding claims, wherein a reflectivity of a reflectivity ratio of the thermally conductive layer (210) to a reflectivity ratio of the thermal insulation wall (202) is greater than or equal to 1.3, preferably, is greater than or equal to 1.4, even more preferably is greater than or equal to 1.5.

10. Arrangement according to any of the preceding claims, wherein a waviness height of the thermally conductive layer (210) is less than or equal to 2 mm, preferably less than or equal 1 mm, even more preferably less than or equal to 0.5 mm.

11. Arrangement according to any of the preceding claims, wherein a thickness ratio of a thickness in the radial direction (r) of the thermally conductive layer (210) to a thickness in the radial direction (r) of the thermal insulation wall (202) is less than or equal to 1/10, preferably, is less than or equal to 1/15, even more preferably is less than or equal to 1/20.

12. Arrangement according to any of the preceding claims, wherein the insulator (200) further comprises at least one heat insulating cover (204) for covering the susceptor (100).

13. System (10) comprising the arrangement according to any of the preceding claims, wherein the system (10) further comprises at least one of an induction heater (300), wherein the induction heater surrounds the insulator (200), a resistance heater, where the resistance heater is surrounded by the insulator (200), a reactor (11) for housing the arrangement, and a vacuum pump for evacuating the reactor (11).

14. Method for growing a SiC volume mono crystal in a cavity (110) by sublimation growth in a direction of growth (Y), the method comprising the steps of:

Providing a SiC seed crystal (120) and SiC source material (130) in the cavity (110);
Heating a susceptor (100) to grow the SiC volume mono crystal in the cavity (130);
Isolating the susceptor (100) with an insulator (200), wherein the insulator (200) comprises:

a thermal insulation wall (202) surrounding the susceptor (100) in the direction of growth (Y) and a circumferential direction, the thermal insulation wall (202) for reducing heat transfer in a radial direction (r) from the susceptor (100) to the exterior outside the arrangement, the radial direction (r) being perpendicular to the direction of growth (Y);
a thermally conductive layer (210) disposed between said susceptor (100) and said thermally insulating wall, said thermally conductive layer (210) having a higher thermal conductivity than said thermally insulating wall, for distributing heat on said thermally conductive layer (210);
wherein the thermally conductive layer (210) is spaced from the susceptor (100) to reduce heat transfer from the susceptor (100) to the insulator (200) caused by thermal conduction, and the thermally conductive layer (210) is disposed on the thermal insulation wall (202), thereby reducing waviness of the insulator (200) to increase reflectivity of the insulator (200).

15. Method according to claim 14, wherein the thermally conductive layer (210) increases the reflectivity so that thermal energy supplied during heating to the susceptor (100) is reduced by more than or equal to 5%, preferably wherein the thermal energy supplied to the cavity is reduced by more than or equal to 10%.

**Amended claims in accordance with Rule 137(2) EPC.**

1. Arrangement for growing a SiC volume monocrystal in a cavity (110) by sublimation growth in a direction of growth (Y), the arrangement comprising

   a susceptor (100) for absorbing electromagnetic energy, the susceptor (100) for heating the cavity (110); and an insulator (200) surrounding the susceptor (100), the insulator (200) for thermally insulating the susceptor (100) from an exterior of the arrangement, the insulator (200) comprising:

   a thermal insulation wall (202) surrounding the susceptor (100) in the direction of growth (Y) and a circumferential direction (c), the thermal insulation wall (202) for reducing heat transfer in a radial direction (r) from the susceptor (100) to the exterior outside the arrangement, the radial direction (r) being perpendicular to the direction of growth (Y);
   a thermally conductive layer (210) disposed between said susceptor (100) and said thermally insulating wall (202), said thermally conductive layer (210) having a higher thermal conductivity than said thermally insulating wall (202), for distributing heat on said thermally conductive layer (210);
   wherein the thermally conductive layer (210) is spaced from the susceptor (100) by a distance in the radial direction (r) equal to or greater than 0.1 mm to reduce heat transfer from the susceptor (100) to the insulator (200) caused by thermal conduction, and the thermally conductive layer (210) is disposed on the thermal insulation wall (202), thereby reducing waviness of the insulator (200) to increase reflectivity of the insulator (200).

2. Arrangement according to claim 1, wherein a thermal conductivity ratio of the thermal conductivity of the thermally conductive layer (210) to the thermal conductivity of the thermal insulation wall (202) is greater than or equal to 10, preferably, is greater than or equal to 14, even more preferably is greater than or equal to 18.

3. Arrangement according to any of the preceding claims, wherein the thermally conductive layer (210) is arranged on the thermal insulation wall (202) by at least one of coating, infiltrating, and foiling the thermal insulation wall (202).

4. Arrangement according to claim 3, wherein the thermally conductive layer (210) is arranged on the thermal insulation wall (202) by coating and/or infiltrating a metal carbide, preferably wherein the metal carbide comprises a refractory metal carbide, optionally wherein the refractory metal carbide comprises at least one of TaC, WC, and HfC.

5. Arrangement according to claim 3 or 4, wherein the thermally conductive layer (210) is arranged on the thermal insulation wall (202) by applying a foil to the thermal insulation wall (202), preferably wherein the foil comprises graphite, optionally wherein the foil comprises exfoliated graphite.

6. Arrangement according to any of the preceding claims, wherein the thermal insulation wall (202) comprises a felt, preferably the thermal insulation wall (202) comprises at least one of a soft felt and a hard felt.

7. Arrangement according to claim 6, wherein the thermal insulation wall (202) comprises graphite insulation material comprising at least one of

   short carbon fibers with a fiber length in a range of between 1 mm and 10 mm and a fiber diameter in a range of between 0.1 mm and 1 mm, wherein the short carbon fibers are bonded by a resin thereby forming a hard felt; and long carbon fibers with a fiber length or greater than 10, wherein the long carbon fibers are bonded by needling to form a soft felt.

8. Arrangement according to any of the preceding claims, wherein the thermal insulation wall (202) is formed by a hollow cylinder extending in the direction of growth (Y) and surrounding in the circumferential direction (c) the susceptor (100), preferably wherein a plurality of coaxial hollow cylinder layers are nested one inside the other, each cylinder layer having a different radius and the cylinder having the smallest radius comprises has the thermally conductive layer (210) on an inner surface facing the susceptor (100).

9. Arrangement according to any of the preceding claims, wherein a reflectivity of a reflectivity ratio of the thermally conductive layer (210) to a reflectivity ratio of the thermal insulation wall (202) is greater than or equal to 1.3, preferably, is greater than or equal to 1.4, even more preferably is greater than or equal to 1.5.

10. Arrangement according to any of the preceding claims, wherein a waviness height of the thermally conductive layer (210) is less than or equal to 2 mm, preferably less than or equal 1 mm, even more preferably less than or equal to 0.5 mm.

11. Arrangement according to any of the preceding claims, wherein a thickness ratio of a thickness in the radial direction (r) of the thermally conductive layer (210) to a thickness in the radial direction (r) of the thermal insulation wall (202) is less than or equal to 1/10, preferably, is less than or equal to 1/15, even more preferably is less than or equal to 1/20.

12. Arrangement according to any of the preceding claims, wherein the insulator (200) further comprises at least one heat insulating cover (204) for covering the susceptor (100).

13. System (10) comprising the arrangement according to any of the preceding claims, wherein the system (10) further comprises at least one of an induction heater (300), wherein the induction heater surrounds the insulator (200), a resistance heater, where the resistance heater is surrounded by the insulator (200), a reactor (11) for housing the arrangement, and a vacuum pump for evacuating the reactor (11).

14. Method for growing a SiC volume mono crystal in a cavity (110) by sublimation growth in a direction of growth (Y), the method comprising the steps of:

> Providing a SiC seed crystal (120) and SiC source material (130) in the cavity (110);
> Heating a susceptor (100) to grow the SiC volume mono crystal in the cavity (130);
> Isolating the susceptor (100) with an insulator (200), wherein the insulator (200) comprises:
>
>> a thermal insulation wall (202) surrounding the susceptor (100) in the direction of growth (Y) and a circumferential direction, the thermal insulation wall (202) for reducing heat transfer in a radial direction (r) from the susceptor (100) to the exterior outside the arrangement, the radial direction (r) being perpendicular to the direction of growth (Y);
>> a thermally conductive layer (210) disposed between said susceptor (100) and said thermally insulating wall, said thermally conductive layer (210) having a higher thermal conductivity than said thermally insulating wall, for distributing heat on said thermally conductive layer (210);
>> wherein the thermally conductive layer (210) is spaced from the susceptor (100) by a distance in the radial direction (r) equal to or greater than 0.1 mm to reduce heat transfer from the susceptor (100) to the insulator (200) caused by thermal conduction, and the thermally conductive layer (210) is disposed on the thermal insulation wall (202), thereby reducing waviness of the insulator (200) to increase reflectivity of the insulator (200).

15. Method according to claim 14, wherein the thermally conductive layer (210) increases the reflectivity so that thermal energy supplied during heating to the susceptor (100) is reduced by more than or equal to 5%, preferably wherein the thermal energy supplied to the cavity is reduced by more than or equal to 10%.

Fig. 1

Fig. 2

Fig. 3

**Start**

S10: Providing a SiC seed
crystal and SiC source
material in a cavity

S12:Isolating a susceptor with
an insulator comprising a
thermal insulation wall and a
thermally conducting layer

S14: Heating the susceptor
to grow a SiC volume
mono crystal in the cavity,
the thermally conducting
layer redirecting radiation
to the susceptor and
distributing heat within it

**End**

Fig. 4

Europäisches
Patentamt

European
Patent Office

Office européen
des brevets

## EUROPEAN SEARCH REPORT

**Application Number**

EP 23 21 7980

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 211 620 664 U (FUJIAN BEIDIAN NEW MATERIAL TECH CO LTD) 2 October 2020 (2020-10-02) * claims 1-3; figures 1-3 * | 1-15 | INV. C30B23/06 C30B29/36 |
| A | US 2010/175614 A1 (STRAUBINGER THOMAS [DE]) 15 July 2010 (2010-07-15) * claims 1-8; figure 1 * | 1-15 | |
| A | CN 218 089 892 U (BEIJING TSINGYAN SEMI CONDUCTIVE TECH CO LTD) 20 December 2022 (2022-12-20) * paragraph [0023] - paragraph [0065]; figure 1 * | 1-15 | |

|  |  |
|---|---|
| | **TECHNICAL FIELDS SEARCHED** (IPC) |
| | C30B |

The present search report has been drawn up for all claims

| Place of search | Date of completion of the search | Examiner |
|---|---|---|
| The Hague | 6 June 2024 | Lavéant, Pierre |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 23 21 7980

This annex lists the patent family members relating to the patent documents cited in the above-mentioned European search report.
The members are as contained in the European Patent Office EDP file on
The European Patent Office is in no way liable for these particulars which are merely given for the purpose of information.

06-06-2024

| Patent document cited in search report | | Publication date | Patent family member(s) | Publication date |
|---|---|---|---|---|
| CN 211620664 | U | 02-10-2020 | NONE | |
| US 2010175614 | A1 | 15-07-2010 | DE 102009004751 A1 | 22-07-2010 |
| | | | US 2010175614 A1 | 15-07-2010 |
| CN 218089892 | U | 20-12-2022 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8747982 B2
- US 8865324 B2
- DE 102009004751 B4